# EUROPEAN PATENT APPLICATION

(11) **EP 2 570 513 A1**
(43) Date of publication of application: **20.03.2013**
(21) Application number: 11192251.4
(22) Date of filing: 06.12.2011
(51) Int. Cl.: C23C 16/46

(54) **Thin film processing equipment and the processing method thereof**

(30) Priority: 16.09.2011 TW 100133379
(71) Applicant: Kern Energy Enterprise Co., Ltd., Taipei City 110 (TW); Yoshimura, Toshiaki, Iruma-shi, Saitama (JP)
(72) Inventor: Yoshimura, Toshiaki, Saitama (JP); Hsiao, Ying-Shih, 110 Taipei City (TW)
(74) Representative: Lang, Christian

(57) **Abstract**

This invention discloses a thin film processing equipment for depositing a film on a substrate and a process for depositing a film on a substrate using the same. The thin film processing equipment comprises a reaction chamber (10), a gas supplying mechanism (21), and a transferring mechanism (30, 32). The thin film processing equipment is characterized in that a gas supplying mechanism is capable of moving up-and-down or left-and-right, and a tray (31) is capable of moving up-and-down, thereby the distance between the gas supplying mechanism and the substrate can be adjusted. The film processing equipment is also provided with a heating device with a pumped circulating heat source to improve the formation of thin films

## Description

### BACKGROUND OF THE INVENTION

### 1. Field of the Invention

The present invention relates to a thin film processing equipment and a process of forming the film using the same, and more particularly to a design of a gas supplying mechanism, which enables kinds of reaction gas to be mixed and accelerates the reaction in the thin film processing equipment.

### 2. Description of the Prior Art

With the development of the semiconductor processing technology, the thin film processing equipments for depositing thin film on a substrate are increasingly used in various products. The major methods for forming the thin film include spattering, depositing and a metal organic chemical vapor deposition (MOCVD). MOCVD is generally used in forming the thin film in the solar photovoltaic industry regarding the advantages of the MOCVD described as follows.
1. By utilizing MOCVD, the components and dopants for forming the compound semiconductor material are introduced into the reaction chamber in the gaseous state. The gaseous flow and the introducing time can be regulated to accurately control the thin film components, dopant concentrations to form a thin film and ultra-thin film materials.
2. The reaction time of gaseous reactions varies from different kinds of gas, thus different reaction times are required in forming the compound semiconductor material. By utilizing MOCVD, the compound components and the dopant concentrations can be controlled and changed in the reaction chamber to suit the formation of heterogeneous structure, superlattice, or quantum-well.
3. Because the formation of the thin film is performed by pyrolysis reaction, the thin film uniformity can be controlled by regulating the reaction gaseous stream and the temperature profile in MOCVD. Thus, MOCVD can be applied to form multiple thin films or large-size thin films for the industrial mass production.
4. Because of the plasma reaction is not used in MOCVD technology, reaction chamber with lower vacuum degree requirement and simpler construction can fulfill the demand of production. Thus the cost of facility can be reduced.

According to above advantages of the MOCVD, the development of MCVD-related technologies and equipments is vigorously increasing. The major method of performing MOCVD is mixing and reacting the organic metal gas with other kinds of gas. The different kinds of gas are provided by different gas supplying ports to introduce those kinds of gas into the reaction chamber to be reacted. Thus, the design of gas supplying port, the relative distance between the gas supplying port and the substrate, and the coordinating heating temperature affect the thin film quality of MOCVD technology and are always considered for designing the reaction chamber.

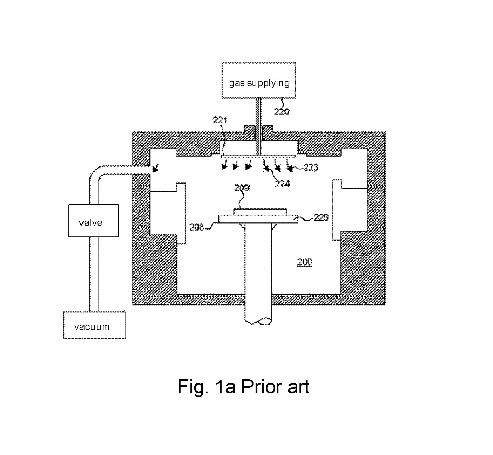

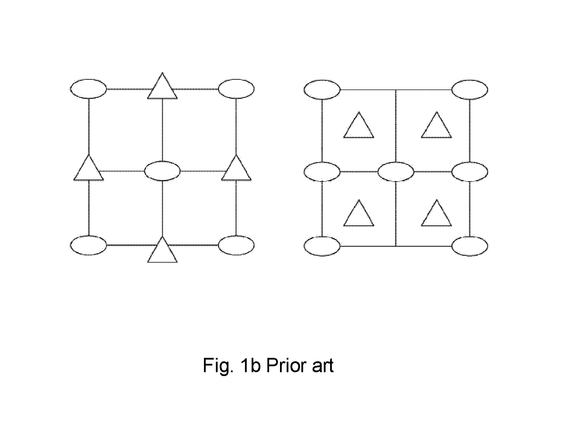

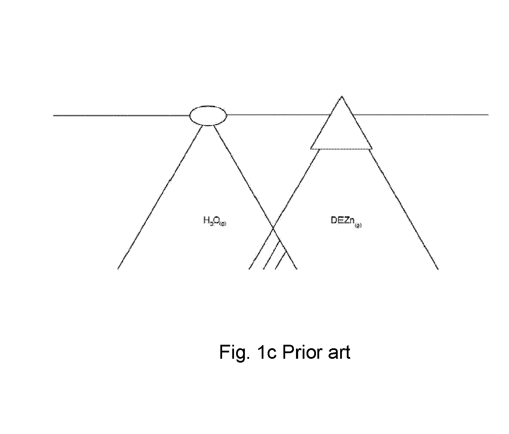

Please refer to Fig. 1a and Fig 1b. Fig. 1a shows a thin film processing equipment according to the conventional prior art. Fig. 1b shows a gas supplying port according to the conventional prior art. As shown in Fig. 1a, the gas 223 and gas 224 are provided by different gas supplying ports respectively, and are sprayed into the reaction chamber 200. In general, the gas supplying ports of the gas supplying mechanism 221 are orthogonal or crisscross arranged as shown in Fig. 1b. However, the orthogonal or crisscross arrangement could not make the kinds of reaction gas to be mixed well. For example, when the gas supplying ports are crisscross arranged, the diethylzinc (DEZn(g)) gas is mixed with the water vapor (H₂O_{(g)}) for reaction, the zinc oxide (ZnO) thin film and acetylene gas (C₂H₂) are generated in the reaction chamber only after the two kinds of gas are mixed well. Obviously, the design of the gas supplying port limits the gas mixing region, as shown in the hatching area in Fig. 1c, such that the efficiency for the gas mixing and the reaction is far from optimum in the reaction chamber. In addition, the acetylene gas is flammable and needs to be removed. Removing the acetylene gas increases the difficultly of controlling the gas uniformity. Thus, the construction of gas supplying mechanism in the thin film processing equipment needs to be improved.

### SUMMARY OF THE INVENTION

In order to solve the above problems in the prior art, one objective of the present invention is to provide a thin film processing equipment provided with a gas supplying mechanism, spraying different kinds of gas to be mixed well, which improves the efficiency of gas mixing and gas reaction such that the quality and uniformity of the thin film become better.

It is another objective of the present invention to provide a thin film processing equipment provided with a gas supplying mechanism and a tray, in which the gas supplying mechanism can be moved up and down or moved around, and the tray can be moved up and down. Thus, the distance between the gas supplying mechanism and the substrate can be adjusted to control the formation of the thin film, such that to improve the quality and efficiency of the formation of the thin film.

It is a further objective of the present invention to provide a thin film processing equipment provided with a heating device which can be moved up and down for each thin film processing equipment. The heating device is provided for heating and insulating the tray and for heating the substrate thereon, such that the reaction can be performed successfully.

It is an objective of the present invention to provide a gas supplying mechanism to remove the waste gas during the gas spraying process, such that the cost of removing the waste gas can be reduced.

It is an objective of the present invention to provide a thin film processing equipment provided with a sensor to monitor the real-time progress of the thin film formation, such that the thin film formation can be maintained well and so as to improve the quality and the efficiency of the thin film formation.

It is an objective of the present invention to provide a process for depositing a thin film on a substrate, such that the efficiency of the thin film formation is improved and simplified in favor of the use by users.

According to above objectives, the present invention provides a thin film processing equipment with the construction described as follows. A tray is provided for supporting a substrate. A reaction chamber which is also a sealed chamber has a top side and bottom side corresponding to the top side. A gas supplying mechanism is disposed in the top side of the reaction chamber and is provided with a pair of gas supplying ports separated from each other for spraying down different kinds of gas. A transferring mechanism is disposed in the bottom side of the reaction chamber for transferring the tray and the substrate into the reaction chamber. The thin film processing equipment is characterized in that the pair of gas supplying ports of the gas supplying mechanism is in form of a concentric-circles structure.

The present invention then provides a thin film processing equipment with the construction described as follows. A tray if provided for supporting a substrate. A reaction chamber which is a sealed chamber has a top side and a bottom side corresponding to the top side. A gas supplying mechanism disposed in the top side of the reaction chamber. The gas supplying mechanism is provided with a plurality of gas supplying ports in form of a concentric-circles structure, and each of the concentric-circles structure is separated from each other for spraying down different kinds of gas. The different kinds of reaction gas are sprayed down through an inner tube and an outer tube of the plurality of gas supplying ports in form of a concentric-circles structure respectively. A transferring mechanism disposed in the bottom side of the reaction chamber is provided for transferring the tray and the substrate into the reaction chamber.

The present invention also provides a thin film processing system described as follows. A tray is provided for supporting a substrate. A first reaction chamber is provided with a heating device. A second reaction chamber is separated from the first reaction chamber by a first valve. The second reaction chamber includes a top side and a bottom side corresponding to the top side. A third reaction chamber is separated from the second reaction chamber by a second valve for providing a cooling environment. A transferring mechanism is disposed in the first, the second and the third reaction chamber for transferring the tray and the substrate into each of the reaction chambers. The thin film processing system is characterized in that: a gas supplying mechanism is disposed in the top side of the second reaction chamber, and the gas supplying mechanism is provided with a plurality of gas supplying ports in form of a concentric-circles structure. Each of gas supplying ports in form of a concentric-circles structure is separated from each other for spraying down different kinds of gas. The different kinds of reaction gas are sprayed down through an inner tube and an outer tube of the gas supplying ports in form of a concentric-circles structure respectively.

The present invention also provides a process for depositing a thin film on a substrate. The process includes the step of providing a tray for supporting a substrate. The step of providing a reaction chamber which is a sealed chamber has a top side and a bottom side corresponding to the top side. The step of providing a gas supplying mechanism disposed in the top side of the reaction chamber. The gas supplying mechanism is provided with at least a pair of gas supplying ports in form of a concentric-circles structure and separated from each other for spraying down different kinds of gas. The gas can be sprayed down through each of the gas supplying ports in form of a concentric-circles structure. The different kinds of reaction gas are sprayed down through an inner tube and an outer tube of the gas supplying ports in form of a concentric-circles structure respectively. The step of providing a transferring mechanism disposed in the bottom side of the reaction chamber for transferring the tray and the substrate into the reaction chamber, such that the substrate is reacted with the different kinds of gas sprayed down by the gas supplying ports.

According to the thin film processing equipment and the process for depositing a thin film on a substrate in the present invention, the gas supplying mechanism provided with a gas supplying port in form of a concentric-circles structure enables the kinds of reaction gas to be mixed well, regulates the distance between the gas supplying port and the substrate, maintains the temperature of the substrate to control the progress and efficiency of the thin film formation, and suits the formation of various thin films.

### BRIEF DESCRIPTION OF THE DRAWINGS

Fig. 1a schematically illustrates the conventional prior art;
Fig. 1b schematically illustrates the gas supplying port of the gas supplying mechanism according to the conventional prior art;
Fig. 1c schematically illustrates the gas mixing in the gas supplying ports of the gas supplying mechanism according to the conventional prior art;
Fig. 2a schematically illustrates the vertical view of the gas supplying port of the gas supplying mechanism in the thin film processing equipment according to the present invention;
Fig. 2b schematically illustrates the cross-sectional view of gas supplying port of the gas supplying mechanism in the thin film processing equipment according to the present invention;
Fig. 2c schematically illustrates the cross-sectional view of the gas supplying mechanism provided with a plurality of gas supplying ports according to the present invention;
Fig. 3 schematically illustrates the gas mixing in the gas supplying ports of the gas supplying mechanism according to the present invention;
Fig. 4a schematically illustrates one embodiment of the substrate according to the present invention;
Fig. 4b schematically illustrates another embodiment of the substrate according to the present invention;
Fig. 4c schematically illustrates the other embodiment of the substrate according to the present invention;
Fig. 5a schematically illustrates one embodiment of the thin film processing equipment according to the present invention;
Fig. 5b schematically illustrates another embodiment of the thin film processing equipment according to the present invention;
Fig. 6a schematically illustrates the movement of the gas supplying mechanism according to the present invention;
Fig. 6b schematically illustrates another movement of the gas supplying mechanism according to the present invention;
Fig. 7a schematically illustrates the load station of the heating device according to the present invention;
Fig. 7b schematically illustrates the top view of the heating deviec according to the present invention;
Fig. 8a schematically illustrates the cross-sectional view of one embodiment of the load station of the heating device according to the present invention;
Fig. 8b schematically illustrates the cross-sectional view of another embodiment of the load station of the heating device according to the present invention;
Fig. 9 schematically illustrates the thickness controller and the sensor of the thin film processing equipment according to the present invention;
Fig. 10a schematically illustrates the lateral view of one embodiment of the thin film processing equipment according to the present invention;
Fig. 10b schematically illustrates the top view of one embodiment of the thin film processing equipment according to the present invention;
Fig. 11a schematically illustrates the lateral view of another embodiment of the thin film processing equipment according to the present invention;
Fig. 11b schematically illustrates the top view of another embodiment of the thin film processing equipment according to the present invention;
Fig. 12a schematically illustrates the lateral view of another embodiment of the thin film processing equipment according to the present invention;
Fig. 12b schematically illustrates the top view of another embodiment of the thin film processing equipment according to the thin film processing equipment according to the present invention;
Fig. 13a schematically illustrates the lateral view of another embodiment of the thin film processing equipment according to the present invention;
Fig. 13b schematically illustrates the top view of another embodiment of the thin film processing equipment according to the present invention;
Fig. 14 schematically illustrates one embodiment of the thin film processing system according to the present invention; and
Fig. 15 schematically illustrates the process for depositing the thin film according to the present invention.

### DESCRIPTION OF THE PREFERRED EMBODIMENT

The present invention relates to the construction and the function of a thin film processing equipment 1 and a process for depositing a thin film 2. For the illustration of the present invention, a metal organic chemical vapor deposition technology (MOCVD) is described herein. Meanwhile, the metal organic chemical vapor deposition technology will be represented with MOCVD subsequently to make the specification readable. The construction and the function of the thin film processing equipment 1 based on MOCVD have been known to persons of ordinary skill in the art and need not to be discussed in any length herewith. Thus, only the characteristics of the thin film processing equipment 1 and the process for depositing a thin film 2 are described in detail. Also, the accompanying drawings referred by the following description are intended to show the characteristics of the present invention and are not made to scale.

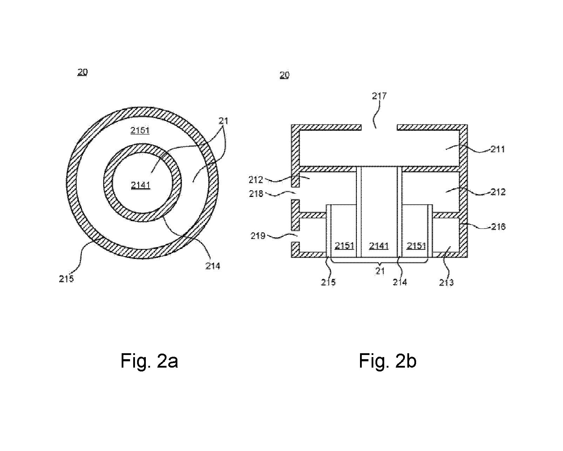

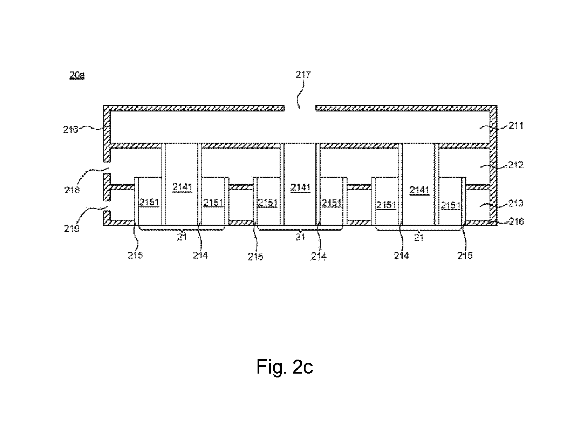

First, please refer to Fig. 2a to Fig. 2c. Fig. 2a shows the vertical view of a gas supplying port of a gas supplying mechanism in the thin film processing equipment, Fig. 2b shows the cross-sectional view of the gas supplying port of the gas supplying mechanism in the thin film processing equipment, and Fig. 2c shows the cross-sectional view of the gas supplying mechanism which is provided with a plurality of gas supplying ports in the thin film processing equipment. In Fig. 2a, the gas supplying port 21 of the gas supplying mechanism 20 is designed to be in form of a concentric-circles structure. The gas supplying port 21 includes an inner tube 214 forming a first flow channel 2141, an outer tube 215 forming a second flow channel 2151 and a shell 216 covering the inner tube 214 and the outer tube 215. Obviously, different kinds of gas are sprayed down from the gas supplying mechanism through the first flow channel 2141 and the second flow channel 2151 respectively. In one embodiment, to form a Zinc oxide (ZnO) film, the diethylzinc (DEZn_{(g)}) gas is sprayed down through the first flow channel 2141 and the water vapor (H₂O_{(g)}) is sprayed down through the second flow channel 2151. The present invention does not limit which one of the kinds of the reaction gas is sprayed down through the first flow channel 2141 or the second flow channel 2151. In other words, the water vapor (H₂O_{(g)}) can be sprayed through the first flow channel 2141 and the diethylzinc (DEZn_{(g)}) gas can be sprayed by the second flow channel 2151.

In another embodiment, to form a magnesium fluoride (MgF₂) thin film as an anti-reflective coating layer (ARC), the bis (methyl cyclopentadienyl) magnesium (( Mg(CH₃C₅H₄)_{2 (g)} )) gas is sprayed down through the first flow channel 2141 and the tetrafluoromethane (CF_{4(g)}) gas is sprayed down thorough the second flow channel 2151 and vice versa. The present invention does not limit which one of the kinds of the reaction gas is sprayed down through the first flow channel 2141 or the second flow channel 2151, and does not limit which type of thin film can be formed in this way. For example, to form a the magnesium fluoride thin film as the ARC film, the source gas of the metal-organic magnesium (metal-organic Mg) includes: bis(cyclopentadientyl)magnesium (Mg(C₅H₅)₂), bis(cyclopentadientyl)magnesium in squalane ( Mg(C₅H₅)₂ in C₃₀H₆₂ ) , bis(methylcyclopentadienyl) magnesium ( Mg(CH₃C₅H₄)₂ ) , and bis(isopropylcyclopentadienyl)magnesium ( Mg(i-C₃H₇C₅H₄)₂. The source gas of fluoride (F) includes tetrafluoromethane (CF₄), tetrafluoroethane (C₂F₄), hexafluoroethane (C₂F₆ ) , octafluoropropane (C₃F₈), nitrogen trifluoride (NF₃ ) , fluorine (F₂ ), hydrogen fluoride (HF), and chlorine trifluoride (ClF₃).

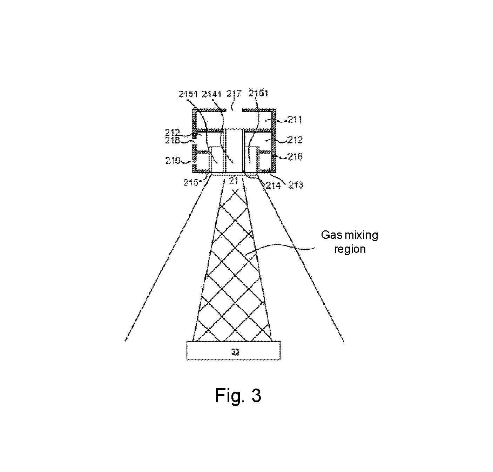

Provided with gas supplying ports 21 in form of a concentric-circles structure, the gas supplying mechanism 20 can increase the gas mixing efficiency as shown in the hatching area in Fig. 3 and obviously improve the drawback of small mixing area in the conventional prior arts. Furthermore, the gas mixing state of the gas supplying port 21 in form of a concentric-circle structure can be anticipated by calculating and adjusting the optimal distance between the gas supplying port 21 of the gas supplying mechanism 20 and the substrate 33, such that the thin film formation efficiency can be improved, and this part will be described subsequently.

Then, according to the cross-sectional view of Fig. 2b, the gas supplying port 21 in form of a concentric-circle structure of the gas supplying mechanism 20 is constructed by two tubes with different length including an inner tube 214 and an outer tube 215. The inner tube 214 is longer than the outer tube 215, and the outer diameter of the inner tube 214 is smaller than that of the inner diameter of the outer tube 215. For example, the inner diameter of inner tube 214 with is in a range from 0.6 mm to 1.0 mm; the outer diameter of the inner tube 214 is in a range from 1.6 mm to 2.0 mm; the inner diameter of the outer tube 215 is in a range from 3.0 mm to 4.0 mm; and the outer diameter of the outer tube 215 is in a range from 4.0 mm to 5.0 mm. In addition, the material of the inner tube 214 and the outer tube 215 includes stainless steel (SUS304, SUS316, SUS316L), carbon composite or graphite. In one preferred embodiment, the surface of the inner tube 214 and the outer tube 215 of the gas supplying mechanism 20 is treated with diamond-like carbon (DLC), silicon dioxide (SiO₂) or silicon carbide (SiC) to change the surface characteristic, and make the surface denser and not being corroded by the reaction gas.

Please refer to Fig. 2b, the other outlet of inner tube 214 and the other outlet of the outer tube 215 are connected with the different flow channels, wherein one end of the first flow channel 2141 formed by the inner tube 214 is an ejecting outlet of the gas supplying port 21, and the other end corresponding to the gas supplying port 21 is intercommunicated with a gas containing chamber 211. Thus, the gas can be introduced into the gas containing chamber 211 via a vent-hole 217. When the first gas containing chamber 211 is full of the reaction gas, the reaction gas is sprayed down from the gas supplying port 21 through the first flow channel 2141. The other end of the second flow channel 2151 formed by the inner tube 215 is another ejecting outlet of the gas supplying port 21, and the other end corresponding to the gas supplying port 2 is intercommunicated with the second gas containing chamber 212. Thus, the reaction gas can be introduced into the second containing chamber 212. When the second gas containing chamber 212 is full of the reaction gas, the reaction gas is sprayed down from the gas supplying port 21 through the second flow channel 2151. The different kinds of reaction gas will not contact to each other inside the gas supplying mechanism 20 due to the inner tube 214 is separated from the outer tube 215. Therefore, there is no danger of the gas reaction. Obviously, the kinds of reaction gas introduced through respectively by the separated inner tube 214 and outer tube 215 will mix until those are sprayed down from the first flow channel 2141 and the second flow channel 215 respectively.

In addition, a third gas containing chamber 213 is added into the gas supplying mechanism 20 in the present invention to provide a heat source which can be introduced into the third gas containing chamber 213 via a vent-hole 219 if necessary, such that the third gas containing chamber 213 can be kept thermal insulating. Thus, the third gas containing chamber 213 provides a heat source for the reaction gas passing through the second flow channel 2151, and keeps the temperature of the sprayed reaction gas within a range. For example, the temperature of the sprayed reaction gas passing through the second flow channel 2151 is kept in a range from 60 °C to 70°C to prevent the dust sedimentation, coagulation or powder collection at the outlets of the first flow channel 2141 and the second flow channel 2151 of the gas supplying port 21 after the gas reaction which result in the blocking of the outlets of the first flow channel 2141 and the second flow channel 2151, which otherwise affecting the gas spraying efficiency, the thin film formation quality, the thin film uniformity, and the thin film formation rate. In addition, the methods of providing heat source of the third gas containing chamber 213 include adding the heat sources of higher temperature such as hot steam, hot water, or hot oil, introducing a heating device, and so on. The method of providing the heat source in the third gas containing chamber 213 is not limited in the present invention. The reaction between the substrate and the kinds of reaction gas will be performed till the temperature of surface of the substrate 33 reaches a specific temperature. To increase the reaction duration between the surface of the substrate 33 and the kinds of reaction gas, another method of heating is to heat the substrate 33. The method of heating and maintaining temperature of the substrate 33 will be described in detail subsequently.

Please refer to Fig. 2c, showing the cross-sectional view of the thin film processing equipment provided with the gas supplying mechanism formed by a plurality of gas supplying ports according to the present invention. As shown in Fig. 2c, the present invention provides a gas supplying mechanism 20 which is provided with a plurality of gas supplying ports 21. The gas supplying mechanism 20 is formed by connecting a plurality of gas supplying ports shown in Fig. 2b. Apparently, in this embodiment, the gas supplying mechanism 20 provided with a plurality of gas supplying ports 21 is formed by a first gas containing chamber, a plurality of second gas containing chamber 212, and a plurality of third gas containing chamber 213; and is intercommunicated with a plurality of first flow channel 2141 and a plurality of second flow channel 2151 through the first gas containing chamber and a plurality of second gas containing chamber 212. Wherein each of the second gas containing chambers 212 of the plurality of the gas supplying ports 21 are intercommunicated with each other, and each of the third gas containing chambers 213 are intercommunicated with each other. Such that the gas is introduced into each of the second gas containing chamber 212 via the vent-hole 218, and when the second gas containing chamber 212 is full of the gas, the gas is sprayed down from each of the gas supplying ports 21 through each of the second flow channel 2151. Similarly, a heat source is introduced into each of the third gas containing chamber 213 to keep each of the third gas containing chamber 213 thermal insulating and keep the temperature of the sprayed reaction gas passing through the second flow channel 2151 with a range. Additionally, another kind of gas is introduced into the firs gas containing chamber 211 via the vent-hole 217, and when the firs gas containing chamber 211 is full of the gas, the gas is sprayed down from each of the gas supplying ports 21 through each of the second flow channel 2141. Obviously, a larger thin film processing can be executed in this embodiment.

Please refer to Fig. 3 showing the gas mixing state in the gas supplying port of the gas supplying mechanism. In Fig. 3, the two gas flows are mixed immediately after being sprayed down from the gas supplying port 21 of the gas supplying mechanism 20. By optimal calculation and measurement, the gas mixture can be set to become homogeneous once the gas mixture reaches the substrate 33 in favor of the reaction and the thin film formation.

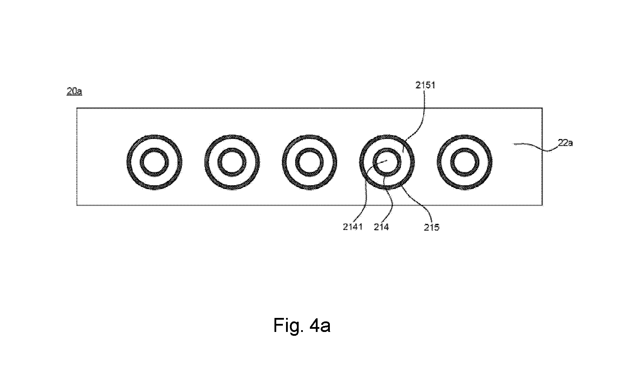

Then, please refer to Fig. 4a. Fig. 4a shows another embodiment of the gas supplying mechanism in the present invention. As shown in Fig. 4a, the gas supplying port 21 in form of a plurality of concentric-circles structure is disposed in a carrier substrate 22a to form a bar-type gas supplying mechanism 20a. Similarly, based on the concentric-circles structure of the gas supplying port 21, kinds of gas are introduced into the first gas containing chamber 211 via a first vent-hole 217 by designing different gas flow channels of the inner tube 214 and the outer tube 215. When the first gas containing chamber 211 is full of the reaction gas, the reaction gas is sprayed down from the gas supplying port 21 through each of the first flow channel 2141. Meanwhile, a reaction gas is introduced into the second gas containing chamber 212 via a second vent-hole 218. When the second gas containing chamber 212 is full of the reaction gas, the reaction gas is sprayed down from the gas supplying port 21 through each of the second flow channel 2151. Obviously, the number of gas supplying port 21 is not limited to form a gas supplying mechanism 20a. Meanwhile, the distance between each of the concentric-circle in the plurality of the concentric-circles structures is not limited, such that a plurality of gas supplying ports with a concentric-circles structure can be arranged as required by the user.

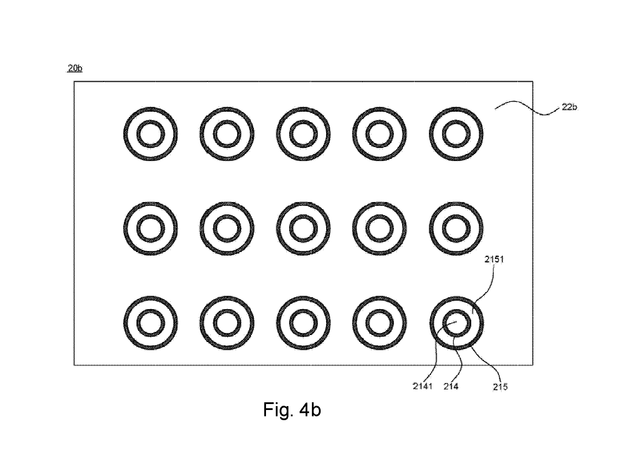

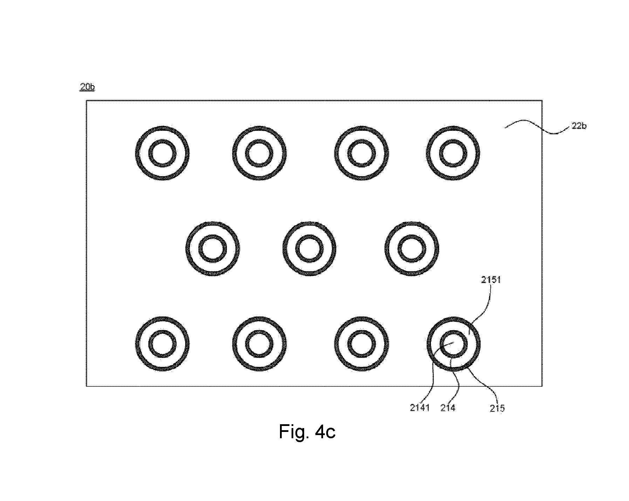

Next, please refer to Fig. 4b. Fig. 4b shows another embodiment of the gas supplying mechanism in the present invention. As shown in Fig. 4b, a plurality of gas supplying ports 21 in form of a concentric-circles structure are disposed in a flat surface of the carrier substrate 22b to form a flat-type gas supplying mechanism 20b. The structure of the gas supplying port in form of a concentric-circles structure is the same as that of the above-mention, thus, it would not be described again. It is emphasized that, the number of the first vent-hole 217 through which the reaction gas passing the first flow channel 2141 can be one or more than one in the embodiment of Fig. 4a, Fig. 4b and Fig. 4c as required by the user.

Next, please refer to Fig. 4c. Fig. 4c shows another embodiment of the gas supplying mechanism in the present invention. As shown in Fig. 4c, a plurality of gas supplying port 21 in form of a concentric-circles structure are disposed in a flat surface of the carrier substrate 22b, to form a flat-type gas supplying mechanism 20b. The difference between Fig. 4c and Fig. 4b is the relative position of the gas supplying port 21, but due to the gas supplying port in form of a concentric-circles structure is the same as that of the above-mention, thus, it would not be described again. It should be emphasized that the number of the first vent-hole 217 through which the reaction gas passing the first flow channel 2141 can be one or more than one in the embodiment of Fig. 4a, Fig. 4b and Fig. 4c as required by the user.

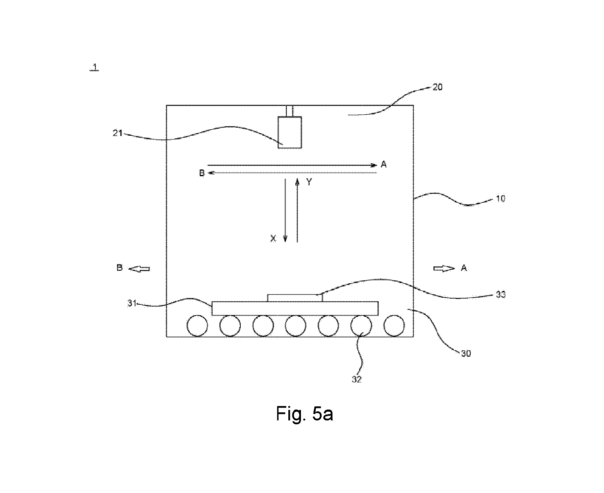

Please refer to Fig. 5a. Fig. 5a shows an embodiment of the thin film processing equipment in this present invention. As shown in Fig. 5a, the thin film processing equipment 1 is used to deposit a thin film on a substrate 33. The thin film processing equipment 1 includes a reaction chamber 10, a gas supplying mechanism 20, a transferring mechanism 30 and a tray 31. The reaction chamber 10 is a sealed chamber in which kinds of reaction gas are reacted to form a thin film under a vacuum environment. The gas supplying mechanism 20 is disposed in the top side of the reaction chamber 10. The gas supplying mechanism 20 is provided with a gas supplying port 21 in form of a concentric-circles structure through which the reaction gas is sprayed down. Thus, the reaction gas can be sprayed down through the gas supplying port 21 in form of a concentric-circles structure of the gas supplying mechanism 20. The transferring mechanism 30 is constructed by a plurality of rolling devices 32 (e.g. a roller) disposed in the bottom side of the reaction chamber 10. The tray 31 is provided for supporting a substrate 33 and is contacted with the rolling device 32 to drive the tray 31 and the substrate 33 moving toward the A direction into the thin film processing equipment 1.

Please refer to Fig. 5a. The process for depositing a thin film in the thin film processing equipment 1 includes the following steps. The substrate 33 is disposed in the tray 31, and the tray 31 is moved toward the A direction by a rolling device 32 to introduce the tray 31 and the substrate 33 into the reaction chamber 10 of the thin film processing equipment 1. The valve (not shown in the figures) of the thin film processing equipment 1 is closed tightly. A pumping process is performed to make the reaction chamber being under a vacuum environment. The kinds of reaction gas is sprayed down from the gas supplying port 21 in form of a concentric-circles structure of the gas supplying mechanism 20, and are reacted to form a thin film on the substrate 33. Obviously, the present embodiment is characterized in that the kinds of reaction gas are sprayed down by the gas supplying port 21 in form of a concentric-circles structure of the gas supplying mechanism 20. For example, to form of the zinc oxide (ZnO) film, the diethylzinc (DEZn_{(g)}) gas is sprayed down through the first flow channel 2141 and the water vapor (H₂O_{(g)}) is sprayed down through the second flow channel 2151 . Alternatively, the water vapor (H₂O_{(g)}) is sprayed down through the first flow channel 2141 and the diethylzinc (DEZn_{(g)}) gas is sprayed down through the second flow channel 2151. Provided with the gas supplying port 21 in form of a concentric-circles structure, the gas supplying mechanism 20 can increase the gas mixing efficiency as shown in the hatching area in Fig. 3 and obviously improve the drawback of small mixing area in the conventional prior art s.

The design of the rolling device 32 of the transferring mechanism 30 in the thin film processing equipment 1 can be rolled clockwise or counterclockwise. Thus, the tray 31 and the substrate 33 can be moved toward the A direction or the B direction. The speed of the rolling device 32 can be kept to control the gas reaction and thus control the thin film formation rate and the thickness of thin film on the substrate 33. For example, if the thin film formation rate is fast, the speed of the rolling device 32 can be increased to control the thickness of the thin film. In contrast, if the thin film formation rate is slow, the speed of the rolling device 32 can be decreased.

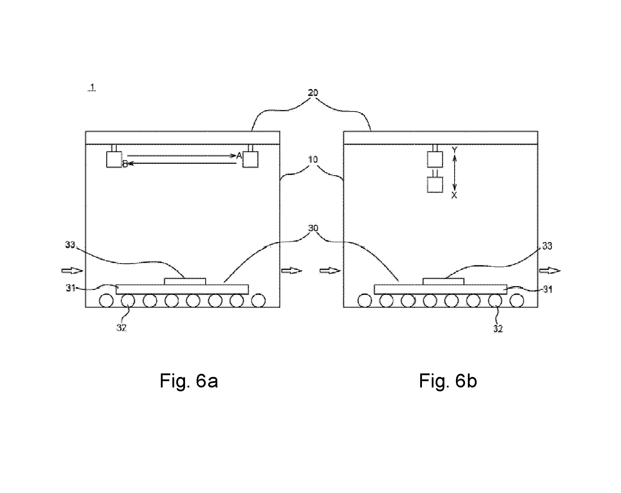

The gas supplying mechanism 20 in the thin film processing equipment 1 can be moved along the A direction or the B direction in the reaction chamber 10 as shown in Fig. 6a. Meanwhile, the gas supplying mechanism 20 can be moved up and down along the X direction and the Y direction in the reaction chamber 10 as shown in Fig. 6b. A direction and B direction are perpendicular to the X direction and the Y direction. Similarly, the thickness of the thin film and the formation rate can be controlled accurately by controlling the movement of the gas supplying mechanism 20. In addition, the method of moving the gas supplying mechanism 20 includes a stepper motor (not shown). Obviously, the previous embodiment using the gas supplying mechanism 20a can also be applied to be moved along the A direction or the B direction, or be moved up and down along the X direction or the Y direction in the reaction chamber 10.

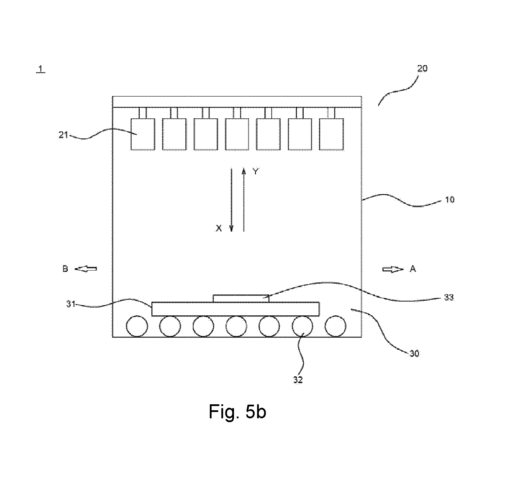

Please refer to Fig. 5b. Fig. 5b shows another embodiment of the thin film processing equipment. As shown in Fig. 5b, the thin film processing equipment 1 includes a reaction chamber 10, a gas supplying mechanism 20b, a transferring mechanism 30, and a tray 31. The reaction chamber 10 is a sealed chamber in which kinds of the reaction gas can be introduced into the reaction chamber 10 to form the thin film under a vacuum environment. The gas supplying mechanism 20b is disposed in the top side of the reaction chamber 10. The gas supplying mechanism 20b is a flat carrier substrate 22b provided with a plurality of gas supplying ports 21 in form of a concentric-circles structure through which the reaction gas is sprayed down. The transferring mechanism 30 is constructed by a plurality of rolling devices 32 disposed in the bottom side of the reaction chamber 10. The tray 31 is provided for supporting a substrate 33 and contacting with the rolling device 32. The tray 31 and the substrate 33 are moved toward the A direction into the thin film processing equipment 1 by the rolling device 32. The difference between Fig. 5a and Fig. 5b is the gas supplying mechanism 20b, which is a flat carrier substrate 22b provided with a plurality of gas supplying ports 21 in form of a concentric-circles structure. Thus, the kinds of reaction gas can be sprayed down from the gas supplying port 21 in form of a concentric-circles structure of the gas supplying mechanism 20b to provide an area for forming the thin film. Thus, in this embodiment of the Fig. 5b, the thin film formation rate and the thickness of the thin film can be controlled accurately by moving the gas supplying mechanism 20b up and down along the X direction or the Y direction. Other process for depositing the thin film in Fig. 5b is the same as Fig. 5a, thus, it would not be described again.

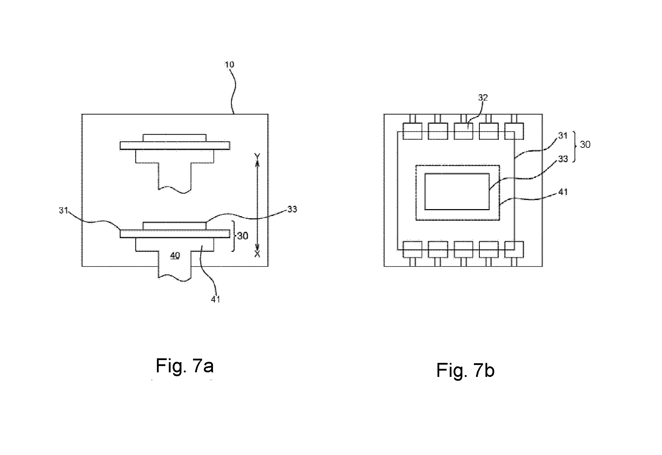

Please refer to Fig. 7a and Fig. 7b showing the thin film processing equipment provided with the heating device. Fig. 7a shows the moving of a heating device 40 in the thin film processing equipment 1 (rolling device 32 is not shown in Fig. 1a). Fig. 7b is a top view of Fig. 7a. As shown in Fig. 7a, after the transferring mechanism 30 is introduced into the reaction chamber 10, the movable heating device 40 is contacted with the tray 31 by the contact between a loading station 41 of the movable heating device 40 and the tray 31. Wherein the loading station 41 of the heating device 40 is capable of being moved up and down (e.g. being moved along the X direction or the Y direction). The tray 31 and the substrate 33 thereon are moved toward the gas supplying port 21 in form of a concentric-circles structure of the gas supplying mechanism 20. The distance between the gas supplying port 21 in form of a concentric-circles structure of the gas supplying mechanism 20 and the substrate 33 can be controlled by moving the loading station 41, which controls the thin film formation rate and the thickness of the thin film. In addition, according to Fig. 7b, the tray 31 is transferred forward or backward by the rolling of the rolling device 32. The dot line of Fig. 7b indicates the size of the loading station 41, and also shows the contact region between the loading station 41 and the tray 31.

Next, the substrate 33 is heated to increase the reaction time of the gas mixture and the surface of the substrate 33. A heating device 40 is capable of heating, maintaining temperature, and moving up and down. The heating device 40 drives the tray 31 and substrate 33 by moving the loading station 41 up and down in the reaction chamber 10, to control the distance between the gas supplying port 21 and the substrate 33 during the thin film formation, such that the thin film formation efficiency can be effectively controlled. The heating device 40 is also capable of heating. The structure of the heating device 40 is described as follows.

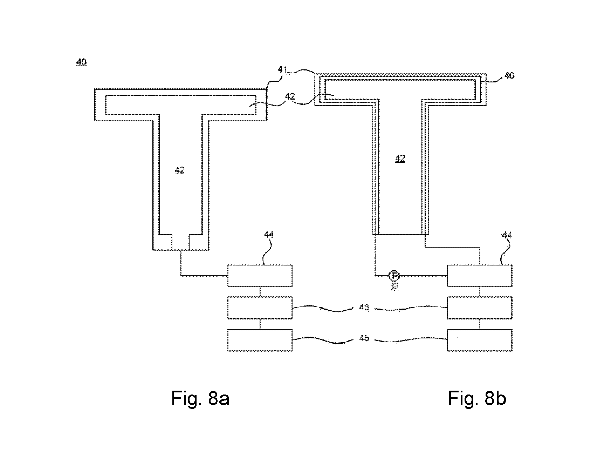

Please refer to Fig. 8a. Fig 8a shows a cross-sectional view of the heating device in the present invention. As shown in Fig. 8a, the heating device 40 is a hollow structure, and a storage region 42 is formed within the heating device 40. The storage region 42 can contain or store the heat source. For example, the heat source is a kind of hot oil in this embodiment. After the oil in the oil source region 44 is heated by a heater 43, the hot oil is introduced into the storage region 42, so as to increase the temperature of the loading station 41 of the heating device 40. When the loading station 41 is raised and contacted with the tray 31, the heat is transmitted from the tray 31 to the substrate 33 and the surface temperature of the substrate 33 is increased. When the storage region 42 of the heating device 40 is continuously heated in an oil bath, the surface temperature of the substrate 33 can be maintained in a certain temperature range to make the kinds of reaction gas reacted adjacently to the loading station 41 and then to extend the reaction time of the gas mixture and the substrate 33. Surely, the oil temperature is controlled by a temperature controller 45. It is emphasized that the reason for controlling the oil temperature to heat the substrate 33 is that the oil temperature can be controlled with accuracy of ±0.5°C. Meanwhile, the oil can be heated up to 350°C which is suitable for depositing the zinc oxide (ZnO) thin film (The operation temperature for the zinc oxide thin film is in a range from 180°C to 230 °C). Thus, due to the characteristics of the accuracy of temperature control and the wide temperature range, in this embodiment, the surface temperature of the substrate 33 can be accurately controlled, so as to control the thickness of the thin film formation accurately. Furthermore, the heating method for heating the oil in the oil source region 44 is not limited in this invention. The heating method also includes halogen, radiant heating, or electrical resistance heating.

Please refer to Fig. 8b. Fig 8b shows another embodiment of a vertical-sectional view of the heating device in this invention. As shown in Fig. 8b, a circulation line 46 is provided in the heating device 40. One end of the circulation line 46 is intercommunicated with the oil source region 44, and another end of that is connected with the oil source region 44. When the oil in the oil source region 44 is heated by the heater 43, the oil is introduced into the circulation line 46 by the pump, circulated back to the oil source region 44, and heated by the heater 43 again. Meanwhile, the embodiment also includes a temperature controller 45 which is used to set and control the temperature to increase the accuracy of temperature. In this way, the heated oil can be circulated in the circulation line 46 to keep the loading station 41 and the substrate 33 thereon at a set temperature.

Comparing the oil bath heating method used in the present invention and the conventional resistance wire heating method, the advantageous feature of oil bath heating is described as follows. For forming the substrate 33 of the size of 300 mm × 300 mm, the required temperature is in a range of 190°C to 201°C. If the conventional resistance wire heating method is utilized, the temperature is set at 200°C to heat the substrate 33 and the temperature of the substrate reaches a range of 189.5°C to 201.5°C. Thus, maintaining the temperature of the substrate 33 in a range from 190°C to 201°C costs more. If the conventional resistance wire heating method is utilized for forming the substrate 33 of the size of 1000 mm × 1000 mm or the larger ones, the temperature of the substrate 33 is even harder to be accurately controlled. Similarly, the temperature is also set at 200°C to heat the substrate 33, the temperature of the substrate 33 reaches a range from 187°C to 203°C, as a result, maintaining the temperature of the substrate 33 in a range from 189.5°C to 201.5°C even costs much more. In contrast, the oil bath heating method in the present invention can reduce the temperature controlling costs, and the temperature controlling costs do not increases as the size of the substrate 33 increases. Thus, the temperature of the substrate 33 can be controlled accurately in a range of the required temperature with accuracy of ±0.5°C. Thus, for heating the substrate 33, the heating efficiency of the oil bath heating method in this invention is better than the conventional resistance wire heating method. Moreover, the design of the circulation line 46 to circulate the oil of the oil bath makes the temperature of the oil bath uniform, makes the oil less susceptible to deterioration and increase the service life.

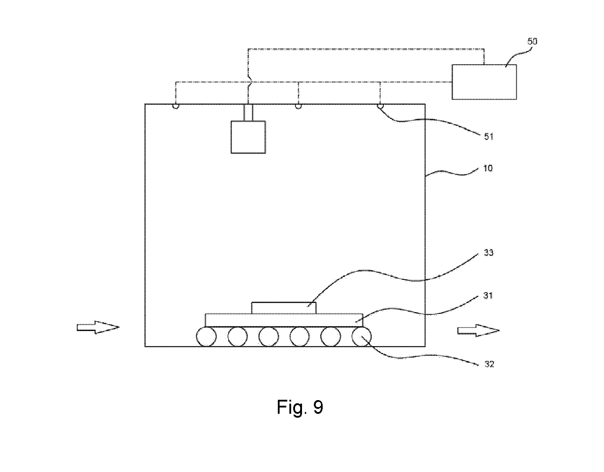

Please refer to Fig. 9. Fig. 9 shows the thickness controller and the sensor of the thin film processing equipment in this invention. As shown in Fig. 9, the top of the thin film processing equipment 1 is provided with at least one sensor 51. The sensor 51 can be arranged to be spaced. The sensing method of this embodiment utilizes a laser or a light beam with a specific wavelength (not shown) to illuminate on the substrate 33. The sensor 51 detects the reflected light signal from the substrate 33, and the signal is transmitted to the thickness controller 50. The thickness or the characteristic of the thin film can be determined by the thickness controller 50. If the determined thickness of the thin film is insufficient, the supply level of the two kinds of reaction gas would be increased to accelerate the thin film formation rate. If the thickness of the thin film is getting higher, the supply level of the two kinds of reaction gas would be decreased to slow down the thin film formation rate. If the quality of the thin film is changed, the ratio for the supply level of the two kinds of reaction gas, the temperature of the heater tuned by the temperature controller can be adjusted, such that the thin film quality can be tuned to be optimal. User can easily set and control the reaction rate of the thin film formation by setting up the thickness controller 50 and the sensor 51 in the thin film processing equipment 1.

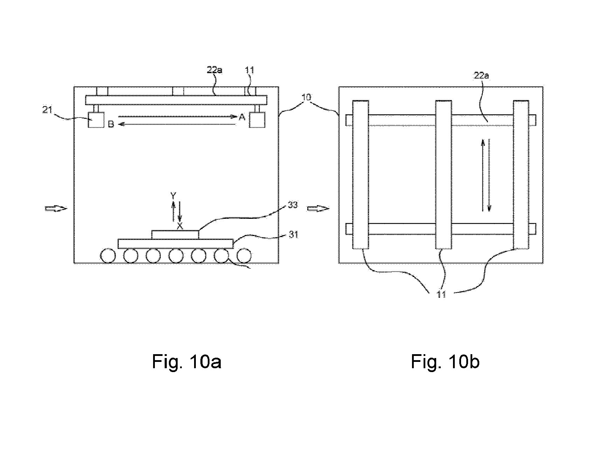

Then, to summarize and describe the aforementioned functions and operations of the thin film processing equipment, please refer to Fig. 10a and Fig. 10b. Fig 10a shows the lateral view of one embodiment of the thin film processing equipment. Fig. 10b is a top view of Fig. 10a. As shown in Fig. 10a, the thin film processing equipment 1 includes a reaction chamber 10, a gas supplying mechanism 20, a transferring mechanism 30 and a tray 31.

The reaction chamber 10 is a sealed chamber in which kinds of reaction gas are reacted to form a thin film under the vacuum environment. The gas supplying mechanism 20 is disposed in the top side of the reaction chamber 10. The gas supplying mechanism 20 is provided with a gas supplying port 21 in form of a concentric-circles structure through which the reaction gas is sprayed down. Thus, the reaction gas can be sprayed down through the gas supplying port 21 with concentric-circles structure of the gas supplying mechanism 20. The transferring mechanism 30 is constructed by a plurality of rolling devices 32 (e.g. a roller) disposed in the bottom side of the reaction chamber 10. The tray 31 is provided for supporting a substrate 33 and is contacted with the rolling device 32 to drive the tray 31 and the substrate 33 moving toward A direction into the thin film processing equipment 1. In this embodiment, the supplying mechanism 20 (e.g. the gas supplying mechanism in Fig. 2a) and the gas supplying mechanism 20a (e.g. the gas supplying mechanism in Fig. 4a) can be moved forward and backward in a first direction driven by a first driving mechanism 22 (such as a stepper motor) disposed in the top side of the reaction chamber 10. Meanwhile, the gas supplying mechanism 20 and the gas supplying mechanism 20a can be moved left and right in a second direction by a second driving mechanism 11 (such as a stepper motor) disposed in the top side of the reaction chamber 10. Thus, the gas supplying mechanism 20 and the gas supplying mechanism 20a can be moved along the two crisscross directions horizontally on the top side of the reaction chamber 10. The gas supplying mechanism 20 and the gas supplying mechanism 20a are can be moved left and right by the driving mechanism 11 and 22, such that the carrier substrate 31 and the substrate 33 can be covered in the moving range. In this embodiment, a heating device 40 is further provided. The loading station 41 of the heating device 40 is contacted with the tray 31. The heating device 40 not only heats the substrate 33 disposed on the tray 31 but also raises the tray 31 and the substrate 33 to shorten the distance between the substrate 33 and gas supplying mechanism 20 and the gas supplying mechanism 20a to control the thin film formation. Emphatically, the driving mechanism 11 and the driving mechanism 12 in Fig. 10a and Fig. 10b are used in conventional technology, thus, the structure of the driving mechanism 11 and the driving mechanism 22 are not described in detail herein, and it would not affect the main feature of the present invention.

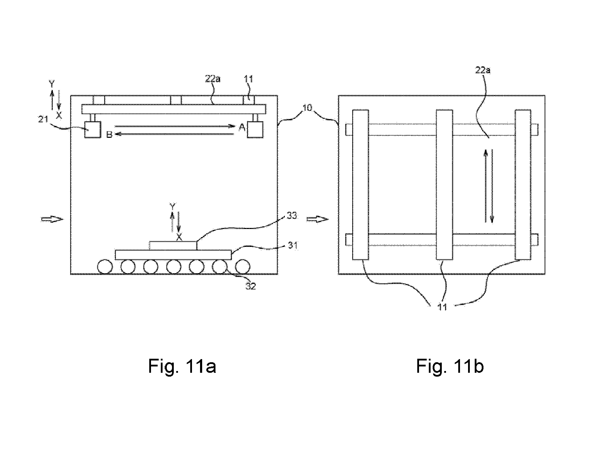

Please refer to Fig. 11a and Fig. 11b. Fig. 11a shows a lateral view of another embodiment of the thin film processing equipment in this invention, and Fig. 11b is a top view of Fig. 11a. Fig. 11a shows an embodiment that the gas supplying mechanism 20 and the gas supplying mechanism 20a are added in the embodiment of Fig. 10a. The gas supplying mechanism 20 and the gas supplying mechanism 20a can be moved along the X direction or the Y direction in the reaction chamber 10, such that the thin film processing equipment 1 is capable of further controlling the thin film formation. Similarly, the driving mechanism 11, 22 and a device driving the gas supplying mechanism 20, and 20a to be moved along the X direction or the Y direction in Fig. 11a and Fig. 11b are used in conventional technology, thus those are not described in detail herein, and it would not affected the main feature of the present invention.

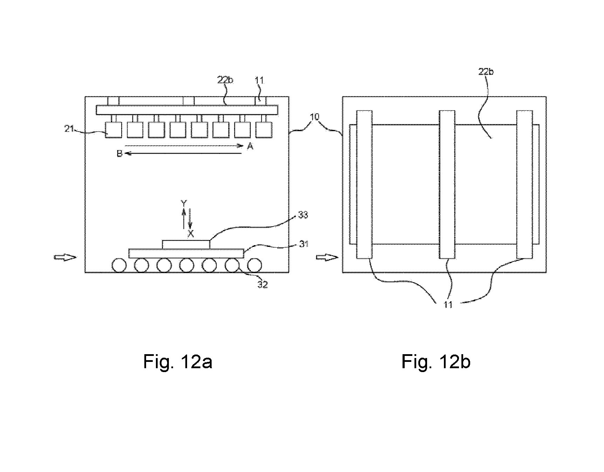

Please refer to Fig. 12a and Fig. 12b. Fig. 12a shows a lateral view of another embodiment of the thin film processing equipment, and Fig. 12b shows a top view of Fig. 12a. As shown in Fig. 12a, the thin film processing equipment includes a reaction chamber 10, a gas supplying mechanism 20b, a transferring mechanism 30, and a tray 31. The reaction chamber 10 is a sealed chamber in which kinds of the reaction gas can be introduced into the reaction chamber 10 to form a thin film under a vacuum environment. The gas supplying mechanism 20b is disposed in the top side of the reaction chamber 10. The gas supplying mechanism 20b is a flat carrier substrate 22b provided with a plurality of gas supplying ports 21 in form of a concentric-circles structure through which the reaction gas is sprayed down to provide an area for forming the thin film. The transferring mechanism 30 is constructed by a plurality of rolling device 32 disposed in the bottom side of the reaction chamber 10. The tray 31 is provided for supporting a substrate 33 and contacting with the rolling device 32. The tray 31 and the substrate 33 are moved toward the A direction driving the tray 31 and the substrate 33 moving toward the A direction into the thin film processing equipment 1 by the rolling device 32. Meanwhile, a heating device 40 is also provided in this embodiment. The loading station 41 of the heating device 40 is contacted with the tray 31. The heating device 40 not only heats the substrate 33 disposed on the tray 31 but also raises the tray 31 and the substrate 33 to shorten the distance between the substrate 33 and gas supplying mechanism 20 and the gas supplying mechanism 20a to control the thin film formation.

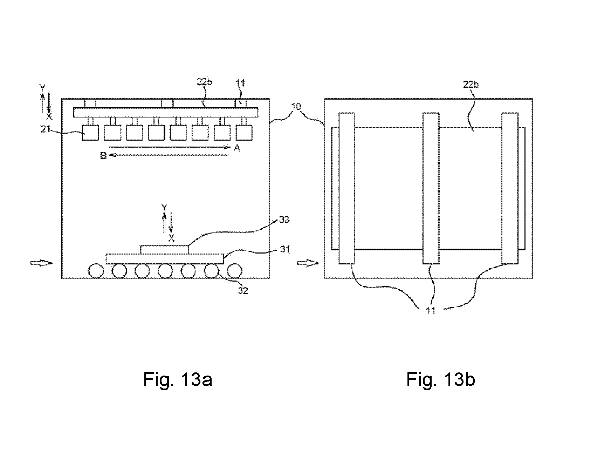

Please refer to Fig. 13a and Fig. 13b. Fig. 13a shows a lateral view of another embodiment of the thin film processing equipment in the present invention, and Fig. 13b shows a top view of Fig. 13a. Fig. 13a shows an embodiment that the function of driving the gas supplying mechanism 20b to be moved along the X direction or the Y direction in the reaction chamber 10 to adjust the distance between the substrate 33 and the gas supplying mechanism 20b, and thus decreasing the time for forming the thin film by the thin film processing equipment.

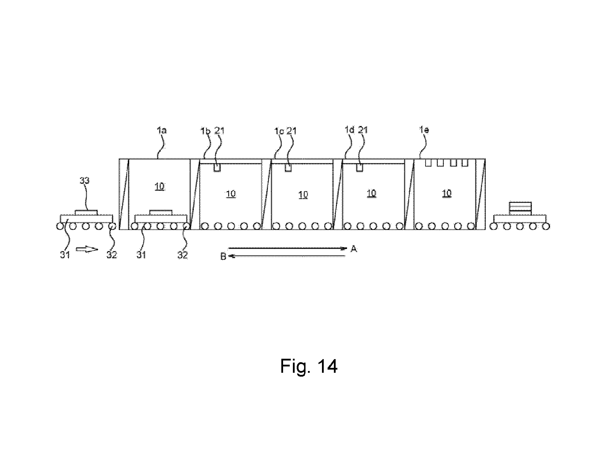

Please refer to Fig. 14. Fig. 14 shows an embodiment of a thin film processing system. As shown in Fig. 14, a plurality of thin film processing equipments 1 are connected to form the thin film processing system. First, the substrate 33 is disposed in the tray 31. The size of the substrate 33 is in a range from 300 mm × 300 mm to 2200 mm × 2500 mm, and the substrate 33 can be a glass substrate. Then, the tray 31 and the substrate 33 are introduced into a first thin film processing equipment 1 along the A direction. While the temperature of the substrate 33 is heated up to a range from 140°C to 220°C by a halogen lamp radiation, a second thin film processing equipment 1b, a third thin film processing equipment 1c and a fourth thin film processing equipment 1d are pumped to be under the vacuum environment with the pressure lower than 0.01 Torr. Each of thin film processing equipments is separated from each other by a valve to well insulate the individual thin film processing equipments. When the valve is closed, the different thin film processing equipments would not be affected by each other, such that the thin film would not be contaminated by each other. The formation of zinc oxide (ZnO) thin film is an example to illustrate the operation of the thin film processing system in this embodiment. When the substrate 33 is introduced into the second thin film processing equipment 1b, two kinds of reaction gas, diethylzinc (DEZn_{(g)}) gas and water vapor (H₂O_{(g)}), are sprayed down in the reaction chamber 10 from the gas supplying mechanism 20 through the gas supplying port 21 in form of a concentric-circles structure. When the gas supplying mechanism 20 is a flat-type gas supplying mechanism 20b, two kinds of reaction gas are sprayed out and mixed to form the thin film after each of the valve of the gas supplying ports 21 are closed. When the gas supplying mechanism 20 is a bar-type gas supplying mechanism 20a, the gas flow can be pre-sprayed down from each of the plurality of gas supplying ports 21 over the tray 31 until the gas flow is under steady state, and then the two kinds of reaction gas are sprayed down to form a thin film on the substrate 33. At the same time, the surface of the substrate 33 can be heated by contacting the loading station 41 (as shown in Fig. 7a) of the heating device 40 with the tray 31 and the surface temperature of the substrate 33 is kept in a range from 140°C to 200°C to form a zinc oxide thin film on the substrate 33. When a thickness of the ZnO thin film reaching a setting value is detected, the spray of the reaction gas is stopped. Then, the tray 31 and the substrate 33 are transferred out from the second thin film processing equipment 1b, and are introduced into the third thin film processing equipment 1c. Meanwhile, based on the kind of reaction gas, the spraying rate, and the setting temperature of the substrate 33 provided by the third thin film processing equipment 1c, different types of thin film can be formed. For example, bis (methyl cyclopentadienyl) magnesium (Mg(CH₃C₅H₄)_{2 (g)}) gas is reacted with the tetrafluoromethane (CF_{4(g)}) gas to form magnesium fluoride ( MgF₂ ) thin film. Similarly, when a thin film is formed in the third thin film processing equipment 1c, the tray 31 and the substrate 33 can be further introduced into the fourth thin film processing equipment 1d to form another thin film. Because the thin film processing equipments 1a, 1b, 1c, and 1d are separated from each other and are not affected by each other, the thin film can be formed as the user's requirement. When the thin film formation is accomplished, the tray 31 and the substrate 33 are introduced into a final thin film processing equipment 1 wherein the nitrogen (N₂) gas is provided to decrease the temperature to a range from 30°C to 60 °C to perform a following procedure. It should be noted that the gas supplying mechanism 20 of any of the thin film processing equipments 1 can be moved up and down or left and right. Meanwhile, the loading station 41 of the heating device 40 can be raised or descended to set the optimal distance between the gas supplying port 21 of the gas supplying mechanism 20 and the substrate 33 to optimally control the thickness of the thin film, and to finally produce thin films with higher quality.

A feature of this invention is further illustrated by taking the formation of zinc oxide (ZnO) thin film for example. The diethylzinc (DEZn_{(g)}) gas is reacted with water vapor (H₂O_{(g)}) not only to form an zinc oxide (ZnO) thin film, but acetylene (C₂H₂) gas, a waste gas to be removed. In order to remove the waste gas, the strengthened pumping is used in the conventional prior art. Unfortunately, over-strengthened pumping affects the uniformity of the stream of reaction gas. Nevertheless, due to the well mixed gas mixture provided by the gas supplying ports 21 in form of a concentric-circles structure of the gas supplying mechanism of the present invention, despite the acetylene (C₂H₂) gas is formed, the reaction gas can be continuously sprayed down from the gas supplying port 21 to replace the acetylene gas, such that the thin film uniformity is not affected by the removal of acetylene gas. Thus, easy removal of the waste gas is an advantage of this invention.

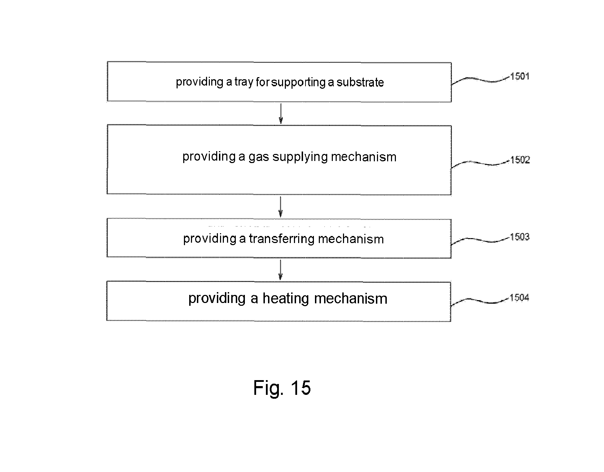

Please refer to Fig. 15. Fig. 15 shows a process flow of the process of depositing the thin film. As shown in Fig 15, the invention provides a process flow 2 for depositing a thin film on the substrate 33 including the steps below. Step 1501: a reaction chamber 10 is provided, which is a sealed chamber, in which the kinds of reaction gas are reacted to form a thin film in the reaction chamber 10. Step 1502: a gas supplying mechanism 20 provided with a gas supplying port 21 is provided and is disposed on the top side of the reaction chamber 10. The reaction gas is sprayed down through the gas supplying port 21, and the gas supply port is in form of a concentric-circles structure. Step 1503: a transferring mechanism 30 is provided and is disposed on the bottom side of the reaction chamber 10 for transferring the substrate 33. Step 1504: a heating device 40 is provided and is disposed under the transferring mechanism 30 with one side contacting with the bottom side of the transferring mechanism 30 to heat the substrate 33.

The present invention has been described by way of examples and with reference to the preferred embodiments and it is understood that the embodiments are not intended to limit the scope of the present invention. Moreover, as the contents disclosed herein should be readily understood and can be implemented by a person skilled in the art, all equivalent changes or modifications which do not depart from the concept of the present invention should be encompassed by the appended claims.

## Claims

1. A thin film processing equipment comprising:
a tray having a first surface and a second surface corresponding to said first surface, and said first surface is provided for supporting a substrate;
a reaction chamber, being a sealed chamber, having a top and a bottom corresponding to said top;
a gas supply mechanism disposed in said top of said reaction chamber;
a transferring mechanism disposed in two sides of said bottom of said reaction chamber for transferring said tray and said substrate into said reaction chamber; and
a heating mechanism disposed in two sides of said bottom of said reaction chamber, being contacted with said second surface of said tray for heating said substrate.

2. A thin film processing equipment comprising:
a tray having a first surface and a second surface corresponding to said first surface, and said first surface is provided for supporting a substrate;
a reaction chamber, being a sealed chamber, having a top and a bottom corresponding to said top;
a gas supply mechanism disposed in said top of said reaction chamber;
a transferring mechanism disposed in two sides of said bottom of said reaction chamber for transferring said tray and said substrate into said reaction chamber; and
a heating mechanism disposed in two sides of said bottom of said reaction chamber, being contacted with said second surface of said tray, being driven by a driving mechanism to move between said top and said bottom of said reaction chamber.

3. The thin film processing equipment according to Claim 1, wherein said heating mechanism includes a storage region therein.

4. The thin film processing equipment according to Claim 2, wherein said heating mechanism includes a storage region therein.

5. The thin film processing equipment according to Claim 1, wherein said gas supplying mechanism is moved between two sides of said top of said reaction chamber by a driving mechanism.

6. The thin film processing equipment according to Claim 2, wherein said gas supplying mechanism is moved between two sides of said top of said reaction chamber by a driving mechanism.

7. The thin film processing equipment according to Claim 1, wherein said gas supplying mechanism is moved between said top and said bottom of said reaction chamber by a driving mechanism.

8. The thin film processing equipment according to Claim 2, wherein said gas supplying mechanism is moved between said top and said bottom of said reaction chamber by a driving mechanism.

9. The thin film processing equipment according to Claim 1 further comprising a plurality of sensors disposed on said top of said reaction chamber.

10. The thin film processing equipment according to Claim 2 further comprising a plurality of sensors disposed on said top of said reaction chamber.

11. A thin film processing system comprising:
a tray having a first surface and a second surface corresponding to said first surface, and said first surface is provided for supporting a substrate;
a first reaction chamber equipped with a heating device;
a second reaction chamber separated from said first reaction chamber by a first valve, having a top and a bottom corresponding to said top;
a third reaction chamber separated from said second reaction chamber by a second valve, for providing a cooling environment; and
a transferring mechanism disposed in two sides of each said bottom of said first reaction chamber, said second reaction chamber, and said third reaction chamber for transferring said tray and said substrate into each of said first reaction chamber, said second reaction chamber and said third reaction chamber;
wherein said thin film processing system is **characterized in that**:
a gas supplying mechanism is disposed in said top of said second reaction chamber, and provided for spraying down different kinds of gas; and
a heating mechanism is disposed in two sides of said bottom of said second reaction chamber, and contacted with said second surface of said tray for heating said substrate.

12. The thin film processing system according to Claim 11, wherein said heating mechanism is moved between said top and said bottom of said second reaction chamber by a driving mechanism.

13. The thin film processing system according to Claim 11, wherein said heating mechanism is moved between two sides of said reaction chamber by a driving mechanism.

14. The thin film processing system according to Claim 11, wherein said gas supplying mechanism is moved between said top and said bottom of said reaction chamber by a driving mechanism.

15. A process for depositing a thin film on a substrate comprising:
providing a tray having a first surface and a second surface corresponding to said first surface, and said first surface is provided for supporting a substrate;
providing a reaction chamber, being a sealed chamber, having a top and a bottom corresponding to said top;
providing a gas supplying mechanism disposed in said top of said reaction chamber for spraying different kinds of gas;
providing a transferring mechanism disposed in two sides of said bottom of said reaction chamber for transferring said tray and said substrate into said reaction chamber; and
providing a heating mechanism disposed in two sides of said bottom of said reaction chamber, being contacted with said second surface of said tray for heating said substrate.
